Europäisches Patentamt

European Patent Office

Office européen des brevets

(11) Publication number: **0 140 979 B1**

# EUROPEAN PATENT SPECIFICATION
## published in accordance with Art. 158(3) EPC

(45) Date of publication of patent specification: 27.02.91

(51) Int. Cl.5: **H01J 1/02, H01J 37/08**

(21) Application number: 84901430.3

(22) Date of filing: 13.04.84

(86) International application number:
PCT/JP84/00188

(87) International publication number:
WO 84/04202 (25.10.84 84/25)

(54) ALLOY CONTAINING LIQUID METAL ION SPECIES.

(30) Priority: 15.04.83 JP 65426/83

(43) Date of publication of application:
15.05.85 Bulletin 85/20

(45) Publication of the grant of the patent:
27.02.91 Bulletin 91/09

(84) Designated Contracting States:
DE GB

(56) References cited:
JP-A-57 131 360
US-A- 4 367 429

**JAPANESE JOURNAL OF APPLIED PHYSICS,
vol. 21, no. 5, May 1982, pages L277-L278; T.
ISHITANI et al.: "Carbon needle emitter for
boron and aluminum ion liquid-metal-ion
sources"**

(73) Proprietor: HITACHI, LTD.
6, Kanda Surugadai 4-chome
Chiyoda-ku, Tokyo 100(JP)

(72) Inventor: TAKAYAMA, Shinji
346, Iguchi Mitaka-shi
Tokyo 181(JP)
Inventor: ISHITANI, Tohru
Seibu Sayamadai Haitsu R 304 1354,
Irumagawa
Sayama-shi Saitama 350-13(JP)
Inventor: TAMURA, Hifumi
10-8, Kiyokawa-cho Hachioji-shi
Tokyo 193(JP)
Inventor: AIDA, Toshiyuki
25-7, Kokuryo-cho
Chofu-shi Tokyo 182(JP)

(74) Representative: **Dost, Wolfgang, Dr.rer.nat., Dipl.-Chem. et al Patent- und Rechtsanwälte Bardehle-Pagenberg-Dost-Altenburg & Partner Postfach 86 06 20 D-8000 München 86(DE)**

**Description**

This invention relates to an ion source material from which ion sources of elements having high melting points, such as B, Si, P or As, can be efficiently and stably drawn out as a single element ion for an extended period of time In a liquid metal ion source.

Development of liquid metal ion sources having high luminance has been earnestly desired to cope with a remarkable progress of the performance of micro-dry processes (e.g. ion beam lithography, dry process, and micro-doping) and submicron surface analysis. In the field of electronic devices in particular, an attempt has been made to directly dope semiconductor material with B, P, Si, As or the like, which is important as a dopant, using a liquid metal ion source. The Principle of the operation of this liquid metal ion source is as follows. First of all, an ion source material which has been melted by resistance heating or electron beam heating is supplied to an emitter chip consisting of W, Ta, C and the like, and a strong electric field is then applied to the tip of the chip so as to draw out ions electrolytically dissociated by the electric field from the tip of the chip. It is therefore important for an ion source that an intended ion beam can be drawn out stably for an extended period.

The article "Carbon needle emitter for boron and aluminum ion liquid-metal-ion-sources," Jap. J. of Appl. Phys., Vol.21, No.5, p.L277-278, by T. Ishitani et.al. discloses $Ni_{50}B_{50}$- alloy and a carbon needle emitter for which source lifetimes of 50-90 hours are obtained using a N;B alloy. Furthermore, alloys having melting points of from 400 to $1,000°C$, such as $Pt_{82}B_{18}$, $Pd_{40}Ni_{40}B_{20}$, $Pt_{27}Ni_{13}B_{60}$, $Au_{36.5}Pt_{20}Ge_{13.5}B_{30}$, $Pd_{40}Ni_{40}B_{10}As_{10}$, $Pt_{72}As_{28}$, or $Pd_{24}Sn_{68}As_8$, have been used as the ion source material of the kind described above. US Patent No. 4,367,429 may be mentioned as an example of the prior art references disclosing such an ion source material.

However, the ion source materials involve the critical problem that the life of the ion source is as short as up to 10 hours owing to either of the following reasons.

1) Since the vapor pressure of the molten ion source material is high, vaporization is so vigorous that the element ion to be drawn out is exhausted within a short period.

2) The emitter chip and the molten ion source material react vigorously with each other so that the drawing out of the ion beam is terminated within a short period.

3) The ion beams are difficultly drawn out because the viscosity of the molten ion source material is too high or its wettability with the emitter chip is poor.

Disclosure of Invention:

It is therefore the object of the present invention to provide an ion source material from which an ion beam of an element having a high melting point, such as B, Si, P or As, can be stably drawn out for a long period. This object is achieved by the liquid metal ion source alloys as defined in the claims.

As described above, the present invention is directed to draw out stably for a long period those ion sources which have high melting points, such as B, Si, P or As. The present invention is completed as a result of extensive studies in order to obtain an ion source material (alloy) which has a low melting point and a low vapor pressure at that temperature, which does not at all react, or hardly reacts, with a glass carbon material or a SiC system, a WC system or a $LaB_6$ system which can be used as the chip material at a high temperature for a long period, and which has high wettability with them.

The inventors of the present invention paid first of all a specific attention to the fact that Ni provides an eutectic alloy having a relatively low melting point (800 to $1,000°C$) with a high melting ion source element such as B, Si, P or As on a lower concentration side (20 to 50 at %) of the element, and then produced ion source materials of the binary alloy systems. When glass carbon or carbide was used as the emitter chip material with the Ni-based binary alloy as the ion source material, however, the following problems were encountered in the same way as in the prior art:

i) The viscosity at the melting point is high.

ii) The wettability with the emitter chip is poor.

iii) Reaction with the emitter chip occurs.

iv) The vapor pressure at the melting point is high and the ion source evaporates soon.

The life of the ion source could be prolonged in comparison with the prior art material, by about 100 hours at most. Claim 1 defines such binary alloy systems which provide improved stability of the ion source. In order to obtain an ion source having a longer life, the inventors attempted to lower the melting point of the Ni-based binary alloy having a composition close to the eutectic alloy composition, and the vapor pressure and the viscosity at that temperature by adding various additional elements, and also to reduce the reactivity with the emitter chip material (principally, glass carbon, carbide, $LaB_6$ or the like) to improve the wettability.

As a result, the inventors have found that the object described above could be accomplished by a liquid metal ion source alloy having a composition represented by the general formula $Ni_aX_b$ where X is at least two elements selected from the group consisting of B, Si, P, C and As, and a and b satisfy the relationships, $30 \leq a \leq 68$ (indicating that the content of Ni is from 30 to 68 at%; the same applies hereinafter) and b = 100 - a. In other words, the liquid ion source alloy of the present invention consists of at least three elements including Ni, and the sum of at least two elements selected from the group consisting of B, Si, P, C and As is from 32 to 70 at%. However, it is preferred that at least 1 at% each of the two elements other than Ni are contained in the alloy, because the amount of the additional element(s) to be added to the Ni-based binary alloy is preferably at least 1 at% in order to enhance the effect of the addition. Even if the amount is below 1 at%, the alloy exhibits better characteristics than the binary alloy, because the additional element exerts its effect even in a trace quantity.

Further preferred additional elements are Si, P and/or C for Ni-B alloy, B, Si and/or C for Ni-P alloy, B for Ni-Si alloy, and B, Si,P and/or C for Ni-As alloy.

The liquid metal ion source alloy of the present invention having the composition described above has a melting point of below about 1000°C, satisfies the target characteristics described already, and has a long life besides the excellent characteristics.

If the alloy is out of the range of the composition described above, the melting point becomes undesirably high.

To obtain B and/or Si ion, a Ni-based alloy which contains B and Si and in which the sum of concentrations of B and Si is from 35 to 70 at% is found suitable and drastically improves the life of the ion source, because not only the melting point is below 1,000°C, but also it hardly reacts with the emitter chip material but has high wettability. In this case, the melting point and viscosity of the alloy can be further reduced and its wettability with the chip material can be further improved by adding up to 20 at% of P and/or C to the alloy system. If the content of P and/or C exceeds 20 at%, the melting point of the alloy is raised, the quantity of the element which can provide the desired ion is reduced and the efficiency of the ion radiation becomes undesirably lower. This composition can be represented by the general formula $Ni_cY_dZ_e$, where Y is B and Si, Z is at least one element of P and C, and C, d and e satisfy the relationships, $30 \leq c \leq 65$, $35 \leq d \leq 70$, $0 \leq e \leq 20$ and $c+d+e = 100$. In this case, too, it is preferable that at least 1 at% each of B and Si is contained in the alloy.

In those ion source alloys which are employed to provide the P ion, it is preferred that the sum of various elements other than Ni (e.g., P, B, C and/or Si) is from 35 to 50 at%. If this condition is satisfied, an ion source having a longer life can be obtained. These alloys are liquid metal ion source alloys having a composition represented by the general formula $Ni_fP_gT_h$, where T is at least one element selected from the group consisting of B, C and Si, and f, g and h satisfy the relationships, $50 \leq f \leq 65$, $35 \leq g+h \leq 50$ and $f+g+h = 100$. In this case, too, it is preferred that each of B, C and/or Si is at least 1 at%.

In those ion source alloys which are employed to provide the As ion it is preferred that the alloys have a composition represented by the general formula $Ni_kAs_lM_m$, where M is at least one element selected from the group consisting of B, Si, C and P, and k, l and m satisfy the relationships, $55 \leq k \leq 65$, $35 \leq l \leq 45$. $0 < m \leq 20$ and $k+l+m = 100$. It is further preferred in this case, too, that at least 1 at% each of B, Si, C and/or P is contained in the alloys.

It was also found that when Ni of the Ni-based alloys was partially substituted (up to 10 at%) by elements such as Cu, Ru, Rh, Pd, Ag, Au or Pt, the melting point of the alloys could be further reduced and the life of the ion source could be further improved. Since heavy metal deteriorates the characteristics of the semiconductor material, the content of the ion source material is preferably limited to 10 at% or below in order to prevent the heavy metal from being incorporated during ion doping. The Ni-based ion source material of the present invention obtained in the manner described above can prolong the life of the ion source over 100 hours particularly when a carbide (SiC or WC), $LaB_6$ or the like is used as the emitter chip material.

The life can be likewise prolonged in the same way as above by substituting part or the whole of Ni of the Ni-based alloy of the invention by Fe or Co. In order to obtain a low melting point of up to 1,000°C in this case, however, the sum of concentrations of Fe, Co and Ni must be from 70 to 85 at%.

As described above, the ion source material in accordance with the present invention is found to be capable of solving the critical problem of the conventional liquid metal ion sources in that the life is short, and is also found to be an excellent material from which high-melting element ion sources such as B, Si, P or As can be drawn out efficiently and stably for an extended period as a single element ion.

Brief Description of the Drawings:

Figure 1 is a longitudinal sectional view of a liquid metal ion source; and

Figure 2 is a diagram of mass analyses of the ion beam when $Ni_{45}B_{45}Si_{10}$ alloy in accordance with one embodiment of the present invention is used as the ion source material.

Best Mode for Carrying Cut the Invention:

Now the present invention will be described in further detail with reference to Examples thereof.

Example 1

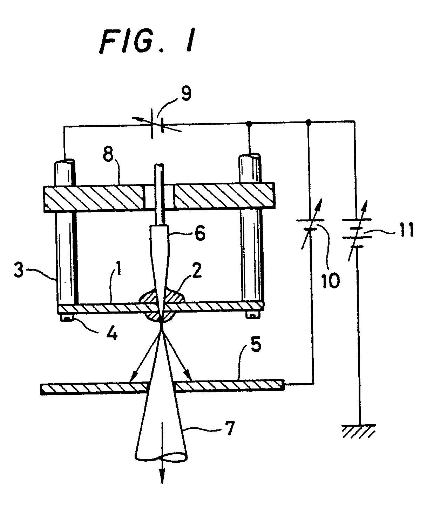

Figure 1 is a schematic diagram of the ion source using the ion source material of the present invention.

The ion source was composed of a resistance heater 1 consisting of a sheet-shaped sintered carbon having a width of 2 to 3 mm, a length of 20 mm and a thickness of 200 $\mu$m, an ion source material 2, a current lead-in terminal 3, a set screw 4, an ion drawing-out electrode 5, a needle-like emitter chip (glass carbon or carbide such as SiC or WC, or $LaB_6$), a support bed 8, a heating power source 9, a drawing-out power source 10, and a heating power source 11. Reference numeral 7 represents ion beams.

$Ni_{50}B_{40}Si_{10}$, $Ni_{45}B_{45}Si_{10}$, $Ni_{45}Cu_5B_{40}Si_{10}$, $Ni_{43}B_{45}Si_{10}C_2$, $Ni_{45}B_{45}P_{10}$ and $Ni_{50}B_{30}Si_{10}P_5C_5$ alloys were used as the ion source materials for the B ion, $Ni_{65}P_{25}C_{10}$, $Ni_{60}P_{30}B_{10}$ and $Ni_{50}Cu_5P_{35}B_{10}$ alloys, as the ion source materials for the P ion, $Ni_{45}Si_{45}B_{10}$, $Ni_{35}Si_{55}B_{10}$ and $Ni_{40}Pd_5Si_{45}B_{10}$ alloys, as the ion source materials for the Si ion, and $Ni_{50}As_{40}Si_{10}$, $Ni_{50}As_{40}B_{10}$ and $Ni_{45}As_{40}B_{10}C_5$ alloys, as the ion source materials for the As ion. These alloys were produced by plasma melting and RF induction heating. The P- or As-containing alloy systems were put into a quartz tube in vacuum after sintering, and were thereafter heated and melted. The melting points of these alloys are tabulated in Table 1. The melting points of $Ni_{50}B_{50}$, $Ni_{50}Si_{50}$, $Ni_{75}P_{25}$ (not falling in the range of claim 1) and $Ni_{60}As_{40}$ alloys are also shown in Table 1 for comparison. It can be understood that the melting points could be further lowered by adding B, P, C, Si, Cu, Pd or the like to the binary alloy systems.

Ion source samples having a diameter of 1 to 2 mm were produced from the alloys prepared above, were placed on the resistance heater 1 shown in Figure 1 and were melted so as to examine the life of the ion sources. As a result, it was confirmed that when glass carbon or SiC or $LaB_6$ was used as the emitter chip material, all the samples showed good wettability with the chip, but hardly reacted with the chip, and the ion beams could be drawn out for more than 100 hours.

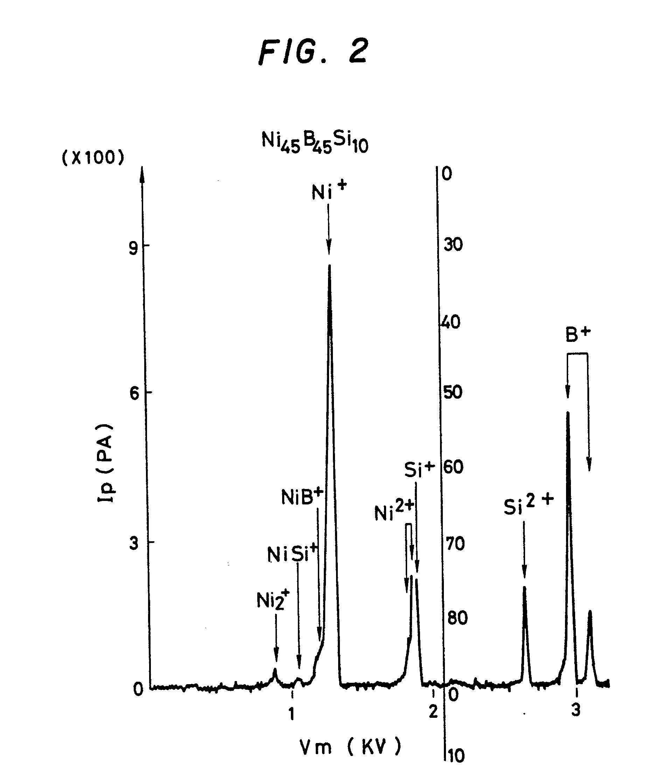

Particularly when the NiBSi alloy as the ion source material and the SiC emitter chip material were combined as the ion source, the wettability with the chip could be remarkably improved, no reaction occurred at all between them, and the ion beams could be drawn out until the molten ion source material was exhausted. Figure 2 shows the mass spectra of ions emitted from an alloy of $Ni_{45}B_{45}Si_{10}$ with an emitted angle of ions in a few m rad as a typical example of the present invention. In this case, the drawing-out voltage was 10.5 kV, and the total ion current was approximately 150 $\mu$A.

## Table 1

| Alloy composition | Melting point Tm ($^\circ$C) |
| --- | --- |
| $Ni_{50}B_{50}$ (prior art, comparison) | 1005 |
| $Ni_{50}B_{40}Si_{10}$ | 930 |
| $Ni_{45}B_{45}Si_{10}$ | 930 |
| $Ni_{45}Cu_5B_{40}Si_{10}$ | 900 |
| $Ni_{45}B_{45}P_{10}$ | 950 |
| $Ni_{50}Si_{50}$ (Comparison) | 970 |
| $Ni_{45}Si_{45}B_{10}$ | 900 |
| $Ni_{35}Si_{55}B_{10}$ | 900 |
| $Ni_{40}Pd_5Si_{45}B_{10}$ | 890 |
| $Ni_{75}P_{25}$ (Comparison) | 990 |
| $Ni_{65}P_{25}C_{10}$ | 900 |
| $Ni_{60}P_{30}B_{10}$ | 910 |
| $Ni_{60}As_{40}$ (Comparison) | 820 |
| $Ni_{50}As_{40}Si_{10}$ | 770 |
| $Ni_{50}As_{40}B_{10}$ | 780 |
| $Ni_{45}As_{40}B_{10}C_5$ | 750 |
| $Ni_{50}B_{30}Si_{10}P_5C_5$ | 920 |
| $Ni_{43}B_{45}Si_{10}C_2$ | 910 |
| $Ni_{50}Cu_5P_{35}B_{10}$ | 900 |

In accordance with the ternary alloy of the present invention, the melting point of the alloy can be lowered and its life as the ion source can be prolonged. The life can also be prolonged in the binary alloys, too, in which only one element selected from the group consisting of P, Si, C and As is used. It was confirmed in this case that an inventive composition was one represented by the general formula $Ni_aX_b$, where X is one element selected from the group consisting of P, Si, C and As, and $\underline{a}$ and $\underline{b}$ satisfy the relationships, $30 \leqq a \leqq 68$ and $b = 100 - a$.

**Claims**

1. A liquid metal ion source alloy having a composition represented by the general formula:
$Ni_aX_b$
where X is one element selected from the group consisting of Si, P, C and As, and $\underline{a}$ and $\underline{b}$ satisfy the relationships, $30 \leq a \leq 68$ and $b = 100 - a$.

2. A liquid metal ion source alloy having a composition represented by the general formula:
$Ni_aX_b$
where X is at least two elements selected from the group consisting of B, Si, P, C and As, and $\underline{a}$ and $\underline{b}$ satisfy the relationships, $30 \leq a \leq 68$ and $b = 100 - a$.

3. A liquid metal ion source alloy as defined in claim 2 herein at least 1 at% each of at least two of said elements constituting said X are contained in said alloy.

4. A liquid metal ion source alloy as defined in claim 2 or 3 wherein said alloy has a composition represented by the general formula:
$Ni_cY_dZ_e$
where Y is B and Si, Z is at least one of P and C, and c, d and e satisfy the relationships, $30 \leq c \leq 65$, $35 \leq d \leq 70$, $0 \leq e \leq 20$, and $c + d + e = 100$.

5. A liquid metal ion source alloy as defined in claim 4 wherein at least 1 at% each of B and Si constituting said Y are contained in said alloy.

6. A liquid metal ion source alloy as defined in claim 2 or 3 wherein said alloy has a composition represented by the general formula:
$Ni_fP_gT_h$
where T is at least one element selected from the group consisting of B, C and Si, and f, g and h satisfy the relationships, $50 \leq f \leq 65$, $355 \leq g + h \leq 50$, and $f + g + h = 100$.

7. A liquid metal ion source alloy as defined in claim 6 wherein $h \geq 1$.

8. A liquid metal ion source alloy as defined in claim 2 or 3 wherein said alloy has a composition represented by the general formula:
$Ni_kAs_lM_m$
where M is at least one element selected from the group consisting of B, Si, C and P, and k, l and m satisfy the relationships, $554 \leq k \leq 65$, $35 \leq l \leq 45$, $0 < m \leq 20$, and $k + l + m = 100$.

9. A liquid metal ion source alloy as defined in claim 8 wherein $m \geq 1$.

10. A liquid metal ion source alloy as defined in any of claims 2 through 9 wherein up to 10 at% of Ni is substituted by at least one element selected from the group consisting of Cu, Ru, Rh, Pd, Ag, Au and Pt.

**Revendications**

1. Alliage de source d'ions de métal liquide ayant une composition représentée par la formule générale:
$Ni_aX_b,$
dans laquelle X est un élément sélectionné dans le groupe consistant en Si, P, C et As, et dans laquelle $\underline{a}$ et $\underline{b}$ satisfont les relations $30 \leq a \leq 68$ et $b = 100 - a$.

2. Alliage de source d'ions de métal liquide ayant une composition représentée par la formule générale:
$Ni_aX_b,$
dans laquelle X est au moins deux éléments sélectionnés dans le groupe consistant en B, Si, P, C et As, et dans laquelle $\underline{a}$ et $\underline{b}$ satisfont les relations $30 \leq a \leq 68$ et $b = 100 - a$.

3. Alliage de source d'ions de métal liquide selon la revendication 2, dans lequel au moins 1 %at de

7

chacun d'au moins deux desdits éléments constituant ledit X sont contenus dans ledit alliage.

4. Alliage de source d'ions de métal liquide selon la revendication 2 ou 3, dans lequel l'alliage a une composition représentée par la formule générale:

$Ni_cY_dZ_e$,

dans laquelle Y est B et Si, Z est au moins un de P et C, et c, d et e satisfont les relations $30 \leq c < 65$ $35 \leq d \leq 70, 0 \leq e \leq 20$, et $c + d + e = 100$.

5. Alliage de source d'ions de métal liquide selon la revendication 4, dans lequel au moins 1 %at de chacun du B et Si constituant ledit Y sont contenus dans ledit alliage.

6. Alliage de source d'ions de métal liquide selon la revendication 2 ou 3, dans lequel ledit alliage a une composition représentée par la formule générale:

$Ni_fP_gT_h$,

dans laquelle T est au moins un élément sélectionné dans le groupe consistant en B, C et Si, et f, g et h satisfont les relations $50 \leq f \leq 65, 35 \leq g + h \leq 50$ et $f + g + h = 100$.

7. Alliage de source d'ions de métal liquide selon la revendication 6, dans lequel $h \geq 1$.

8. Alliage de source d'ions de métal liquide selon la revendication 2 ou 3, dans lequel ledit alliage a une composition représentée par la formule générale:

$Ni_kAs_lM_m$,

dans laquelle M est au moins un élément sélectionné dans le groupe consistant en B, Si, C et P, et k, l et m satisfont les relations $55 \leq k \leq 65, 35 \leq 1 \leq 45, 0 \leq m \leq 20$, et $k + l + m = 100$.

9. Alliage de source d'ions de métal liquide selon la revendication 8, dans lequel $m \geq 1$.

10. Alliage de source d'ions de métal liquide selon l'une des revendications 2 à 9, dans lequel jusqu'à 10 %at de Ni est substitué par au moins un élément sélectionné dans le groupe consistant de Cu, Ru, Rh, Pd, Ag, Au et Pt.

## Ansprüche

1. Flüssigmetall-Ionenquellen-Legierung mit einer Zusammensetzung, die durch die allgemeine Formel dargestellt wird:

$Ni_aX_b$,

wobei X ein Element ist, das aus der Gruppe ausgewählt ist, die aus Si, P, C und As besteht, und wobei a und b den Beziehungen $30 \leq a \leq 68$ und $b = 100 - a$ genügen.

2. Flüssigmetall-Ionenquellen-Legierung mit einer Zusammensetzung, die durch die allgemeine Formel dargestellt wird:

$Ni_aX_b$,

wobei X mindestens aus zwei Elementen besteht, die aus der Gruppe ausgewählt sind, die aus B, Si, P, C und As besteht, und wobei a und b den Beziehungen $30 \leq a \leq 68$ und $b = 100 - 1$ genügen.

3. Flüssigmetall-Ionenquellen-Legierung nach Anspruch 2, wobei mindestens 1 at% jedes von mindestens zwei der Elemente, die das X bilden, in der Legierung enthalten sind.

4. Flüssigmetall-Ionenquellen-Legierung nach Anspruch 2 oder 3, wobei die Legierung eine Zusammensetzung hat, die durch die allgemeine Formel dargestellt wird:

$Ni_cY_dZ_e$,

wobei Y B und Si ist, Z zumindest eines von P und C ist, und c, d und e den Beziehungen $30 \leq c \leq 65$, $35 \leq d \leq 70$ $0 \leq e \leq 20$ genügen, und $c + d + e = 100$ ist.

5. Flüssigmetall-Ionenquellen-Legierung nach Anspruch 4, wobei zumindest 1 at% jedes von B und Si, die das Y bilden, in der Legierung enthalten sind.

6. Flüssigmetall-Ionenquellen-Legierung nach Anspruch 2 oder 3, wobei die Legierung eine Zusammensetzung hat, die durch die allgemeine Formel dargestellt wird:

$Ni_f P_g T_h$,

wobei T zumindest ein Element ist, das aus der Gruppe ausgewählt ist, die aus B, C und Si besteht, und wobei f, g und h den Beziehungen $50 \leq f \leq 65$, $35 \leq g+h \leq 50$, und $f+g+h = 100$ genügen.

7. Flüssigmetall-Ionenquellen-Legierung nach Anspruch 6, wobei $h \geq 1$.

8. Flüssigmetall-Ionenquellen-Legierung nach Anspruch 2 oder 3, wobei die Legierung eine Zusammensetzung hat, die durch die allgemeine Formel dargestellt wird:

$Ni_k As_l M_m$,

wobei M zumindest ein Element ist, das aus der Gruppe ausgewählt ist, die aus B, Si, C und P besteht, und wobei k, l und m den Beziehungen $55 \leq k \leq 65$, $35 \leq l \leq 45$, $0 \leq m \leq 20$ und $k+l+m = 100$ genügen.

9. Flüssigmetall-Ionenquellen-Legierung nach Anspruch 8, wobei $m \geq 1$.

10. Flüssigmetall-Ionenquellen-Legierung nach einem der Ansprüche 2 bis 9, wobei bis zu 10 at% von Ni durch zumindest ein Element ersetzt wird, das aus der Gruppe ausgewählt wird, die aus Cu, Ru, Rh, Pd, Ag, Au und Pt besteht.

## FIG. 1

FIG. 2